# EUROPÄISCHE PATENTSCHRIFT

(11) **EP 1 761 936 B1**
(45) Veröffentlichungstag und Bekanntmachung des Hinweises auf die Patenterteilung: **10.05.2017**
(21) Anmeldenummer: 05782178.7
(22) Anmeldetag: 30.06.2005
(51) Int. Cl.: H01C 1/144, H01G 4/232, H01G 2/06

(54) **ELEKTRISCHES MEHRSCHICHTBAUELEMENT MIT ZUVERLÄSSIGEM LÖTKONTAKT**
ELECTRICAL MULTI-LAYERED COMPONENT HAVING A RELIABLE SOLDERING CONTACT
COMPOSANT MULTICOUCHE ELECTRIQUE PRESENTANT UN CONTACT A BRASER FIABLE

(30) Priorität: 01.07.2004 DE 102004031878
(43) Veröffentlichungstag der Anmeldung: 14.03.2007
(73) Patentinhaber: EPCOS AG, 81669 München (DE)
(72) Erfinder: BLOCK, Christian, A-8510 Stainz (AT); BRUNNER, Sebastian, A-8042 Graz (AT); FEICHTINGER, Thomas, A-8010 Graz (AT); PUDMICH, Günter, A-8580 Köflach (AT)
(74) Vertreter: Epping - Hermann - Fischer
(86) Internationale Anmeldenummer: PCT/DE2005/001155
(87) Internationale Veröffentlichungsnummer: WO 2006/002615

(56) Entgegenhaltungen:
- US-A1- 2002 046 880
- US-A1- 2004 072 436
- US-B1- 6 187 418
- US-B1- 6 203 926
- US-B1- 6 225 569
- US-B1- 6 351 369

## Beschreibung

Die Erfindung betrifft ein elektrisches Mehrschichtbauelement dessen Grundkörper aus Dielektrikumsschichten aufgebaut ist, zwischen denen als Bauelementstrukturen ausgebildete Metallisierungsebenen angeordnet sind.

Derartige Mehrschichtbauelemente können je nach Beschaffenheit der Dielektrikumsschichten und der Elektrodenschichten beispielsweise als Kondensatoren, Varistoren oder temperaturabhängige Widerstände (Thermistoren) eingesetzt werden.

Aus der US 6,351,369 B1 ist ein keramischer Mehrschichtkondensator bekannt.
Mehrschichtbauelemente mit im Querschnitt variierenden Durchkontaktierungen sind aus der US 6,187,418 B1 und der US 2002/0046880 bekannt.

Aus der Druckschrift DE 199 31 056 A1 ist ein Vielschichtvaristor bekannt, bei dem zur Senkung des Widerstandes nicht überlappende Innenelektroden im Inneren des Grundkörpers angeordnet sind. Die Innenelektroden werden dabei auf den beiden Stirnseiten des Bauelements von großflächigen Kontaktschichten kontaktiert, die eine SMD-Montage des Bauelements erlauben. Der Nachteil eines solchen herkömmlichen Bauelements besteht darin, dass aufgrund der großflächigen Kontaktschichten parasitäre Kapazitäten und Induktivitäten aufgebaut werden, die eine genaue Einstellung der elektrischen Charakteristika des Bauelements schwierig macht. Weiterhin benötigt ein derartiges Bauelement aufgrund der großen Kontaktschichten entsprechend viel Platz bei der Montage auf zum Beispiel Platinen. Weiterhin sind vor allem auch Module in dieser Bauweise, in die mehrere dieser Bauelemente integriert sind, besonders groß und weisen damit eine besonders niedrige Integrationsdichte auf.

Es sind auch Mehrschichtbauelemente bekannt, die mittels Flip-Chip Montage auf einer PCB Leiterplatte befestigt werden können. Dazu weisen sie auf der Unterseite lötfähige Kontakte auf, die ein Auflöten auf die PCB Leiterplatte mittels Bumps ermöglichen. Da ein derartiges Bauelement meist über eine Vielzahl von Bumps befestigt ist und sich das Material des Mehrschichtbauelemente von dem des PCB unterscheidet, können insbesondere bei Temperaturwechseln hohe mechanische Spannungen auftreten, die die Lötstellen und insbesondere die damit verbundenen Metallisierungen belasten. Es können sich daher Bumps von den Lötkontakten lösen, die Lötkontakte können sich vom Mehrschichtbauelement lösen oder die mit den Lötkontakten verbundenen und die Verbindung zu innen liegenden Bauelementstrukturen herstellenden Durchkontaktierungen können von den Bumps aus der untersten Dielektrikumsschicht herausgezogen werden.

Aufgabe der vorliegenden Erfindung ist es daher, ein elektrisches Mehrschichtbauelement mit keramischem Grundkörper anzugeben, welches einen stabilen und belastungsfähigen Lötkontakt aufweist.

Diese Aufgabe wird erfindungsgemäß durch ein Mehrschichtbauelement mit den Merkmalen von Anspruch 1 gelöst. Vorteilhafte Ausgestaltungen der Erfindung gehen aus weiteren Ansprüchen hervor.

Die Erfindung schlägt vor, im Grundkörper des Mehrschichtbauelements zumindest die Durchkontaktierungen, die mit dem auf der Unterseite des Grundkörpers aufgebrachten Lötkontakten in Verbindung stehen, so auszugestalten, dass sich ihr Querschnitt nach oben hin, also vom Lötkontakt wegweisend erweitert. Auf diese Weise wird eine Durchkontaktierung und ein damit verbundener Lötkontakt erhalten, der aufgrund der sich nach oben hin erweiternden Durchkontaktierung einen sicheren Halt im Grundkörper besitzt. Die Durchkontaktierung, die aus einer entsprechenden Bohrung in der Dielektrikumsschicht und der darin angeordneten Metallisierung besteht, ist auf diese Weise gegen ein Herausziehen aus dem Grundkörper gesichert. Das Abreißen des Lötkontakts durch Kräfte, die auf den Lötkontakt nach der Verlötung auf z.B. einer Leiterplatte einwirken, ist dadurch erschwert.

Sie Erweiterung der Durchkontaktierungen wird erfindungsgemäß dadurch erreicht, dass die Durchkontaktierung durch zwei direkt benachbarte Teilschichten einer Dielektrikumsschicht geführt und mit den Lötkontakten verbunden ist, wobei die Durchkontaktierung in jeder der beiden Teilschichten vertikale Seitenwände und unterschiedlichen Durchmesser aufweist und wobei der Durchmesser der Durchkontaktierung in der vom Lötkontakt weiter entfernten Teilschicht größer ist als der einer näher am Lötkontakt liegenden Teilschicht.

Der Grundkörper selbst umfasst mehrere übereinander gestapelte keramische Dielektrikumsschichten, zwischen denen zu Bauelementstrukturen strukturierte Metallisierungsebenen vorgesehen sind. Die interne elektrische Verbindung zwischen unterschiedlichen Metallisierungsebenen sowie zwischen den Bauelementstrukturen und den Lötkontakten wird über Durchkontak tierungen vorgenommen, die jeweils durch eine oder mehrere der dielektrischen Schichten reichen können. Im erfindungsgemäßen Bauelement können sämtliche Durchkontaktierungen in erfindungsgemäßer Weise ausgestaltet sein, zumindest aber diejenigen, die mit den Lötkontakten auf der Unterseite des Grundkörpers verbunden sind.

Ferner können die Dielektrikumsschichten vorteilhafterweise eine Elektrokeramik umfassen. Das keramische Material kann damit eine Varistorkeramik auf der Basis von ZnO-Bi oder ZnO-Pr umfassen. Das keramische Material kann weiterhin eine Kondensatorkeramik umfassen, die ausgewählt ist aus sogenannten NP0-Keramiken, z.B. (Sm,Pa) NiCdO3. Diese Keramiken weisen temperaturabhängige Er-Werte auf und sind nicht-ferroelektrische Keramiken. Weiterhin können auch ferroelektrische Keramiken mit hohen Dielektrizitätskonstanten, sowie dotiertes BaTiO₃ und sog. Sperrschichtkeramiken verwendet werden. Diese dielektrischen Keramiken werden im Buch "Keramik" von H. Schaumburg (Hrsg.), B.G. Teubner-Verlag Stuttgart 1994 auf den Seiten 351 bis 352 und 363 beschrieben, wobei auf diese Seiten vollinhaltlich Bezug genommen wird. Darüber hinaus kann das keramische Material aus Thermistorkeramiken, NTC-Keramiken, z.B. Nickel Mangan Spinelle und Perowskite ausgewählt sein. Es können aber auch dielektrische nichtkeramische Materialien, z.B. Gläser verwendet werden.

Weiterhin sind bei dem erfindungsgemäßen Bauelement vorteilhafterweise alle Dielektrikumschichten entweder eine Varistor-, Thermistor- oder Kondensatorkeramik, so dass keine Dielektrikumsschichten im Grundkörper vorhanden sind, die nicht eine dieser elektrischen Eigenschaften aufweisen.

In einer Ausgestaltung der Erfindung ist der Querschnitt der Durchkontaktierungen in einem mittleren Abschnitt am geringsten und erweitert sich ausgehend von diesem mittleren Abschnitt nach oben und nach unten hin, wobei "nach unten" in Richtung zur Unterseite des Bauelements hin bedeutet, "nach oben" dagegen in die entgegengesetzte Richtung.

Diese Ausführung zeichnet sich dadurch aus, dass im Bereich der Durchkontaktierung bzw. deren Bohrung eine maximale Kontaktfläche mit der oder den dielektrischen Schichten zur Verfügung steht, durch die die Durchkontaktierung hindurchgeführt ist. Gleichzeitig weist eine solche Durchkontaktierung eine maximale Kontaktfläche sowohl mit dem Lötkontakt als auch mit der Bauelementstruktur auf, die über die Durchkontaktierung mit dem Lötkontakt verbunden ist. Auf diese Weise wird ein besonders guter Sitz der Durchkontaktierung und damit ein besonders guter Halt der Lötkontakte und damit eine hohe Stabilität des Bauelements gewährleistet.

Die Lötkontakte sind zumindest in dem Flächenbereich vorgesehen, der der Schnittfläche der zur Unterseite des Grundkörpers führenden Durchkontaktierung mit dieser Unterseite entspricht. Bei stark miniaturisierten Bauelementen bzw. bei kleinen Grundkörpern und kleinen Durchmessern der Durchkontaktierungen kann diese Fläche allein zum Herstellen eines Lötkontakts ausreichend sein. Ausreichend ist die Fläche auch dann, wenn der Durchmesser der Bumps, die mit dem Lötkontakt verbunden werden, annähernd gleich dem Durchmesser der jeweiligen Durchkontaktierung an der Unterseite. Dies betrifft insbesondere Bauelemente, bei denen eine Vielzahl von Bumps erforderlich sind, um die notwendigen elektrischen Verbindungen des Bauelements herzustellen, wobei die Durchmesser der Bumps dann z.B. im Bereich 30 - 100 µm liegen.

In den anderen Fällen und bei größeren Bumps erfordert der Lötkontakt eine größere Fläche und wird auf der Unterseite des Grundkörpers so aufgebracht, dass er teilweise noch die unterste keramische Dielektrikumsschicht überlappt bzw. auf dieser zum Aufliegen kommt. In einem solchen Fall ist es vorteilhaft, die direkt mit der keramischen Dielektrikumsschicht in Kontakt stehende Teilschicht des Lötkontakts mit einem Glasanteil auszustatten, der eine bessere Haftung auf der keramischen Dielektrikumsschicht gewährleistet. Neben dem Glasanteil umfasst diese Schicht dann zumindest noch ein Metall oder eine Metalllegierung. Ein solcher Art Lötkontakt wird vorzugsweise in Form einer druckbaren Paste aufgebracht und wird beispielsweise eingebrannt.

In einer Ausgestaltung der Erfindung umfassen die Lötkontakte eine Schicht, deren Material ausgewählt ist aus Zinn (Sn), Zinnbleilegierung (SnPb), Zinnsilberkupferlegierung (SnAgCu), Zinnsilberkupferwismutlegierung (SnAgCuBi), Zinnzinklegierung (SnZn) und Zinnsilberlegierung (SnAg). Der Lötkontakt kann auch weitere Schichten umfassen, die aus diesem Spektrum ausgewählt sind.

Vorteilhaft wird im Lötkontakt eine Diffusionssperrschicht vorgesehen. Diese verhindert, dass es beim Verlöten des Bauelements, also beim Aufbringen oder Auflöten des Bumps auf den Lötkontakt zu einer Legierungsbildung mit Bestandteilen der Metallisierung innerhalb der Durchkontaktierung kommt, die deren Eigenschaften unzulässig verändern oder gar eine Auftrennung der elektrischen Verbindung zu Folge haben könnten. Insbesondere ist dies bei der Verwendung bleifreier Lote von Vorteil, da das Material dieser Lote besonders zur Legierungsbildung mit den vorzugsweise in den Durchkontaktierungen verwendeten Silber und Palladium neigt.

Die Diffusionssperrschicht zur Verhinderung von Legierungsbildung ist vorteilhaft ausgewählt aus Nickel, Zinn und Gold. Die Diffusionssperrschicht kann nahe an der Durchkontaktierung oder auch in einem weiter von der Durchkontaktierung entfernten Schichtbereich des Lötkontakts angeordnet werden. Bei Lötkontakten, deren Fläche sich auf die Öffnung der Durchkontaktierung beschränkt, kann der Lötkontakt allein aus der dann direkt und ausschließlich über der Durchkontaktierung erzeugten Diffusionssperrschicht bestehen.

Als äußerste Schicht weist der Lötkontakt vorteilhaft eine Oxidationsschutzschicht auf, mit der beispielsweise die Oxidation der direkt darunter liegenden Schicht des Lötkontakts, z.B. einer als Diffusionssperrschicht verwendeten Nickelschicht verhindert werden kann. Eine solche Oxidationsschutzschicht kann beispielsweise ausgewählt sein aus Gold, Zinn und einer organischen Schicht. Während eine Gold umfassende Oxidationsschutzschicht dauerhaft den Lötkontakt schützt, kann die Zinnschicht während des Verlötens auch legiert werden, was aber nicht störend ist. Die organische Oxidationsschicht dagegen wird während des Lötvorgangs oxidativ zerstört oder verdampft. Nach dem Verlöten ist keine Oxidationsschutzschicht mehr erforderlich, da eine Oxidation bestenfalls noch oberflächlich stattfinden kann und den Strompfad nicht mehr unterbrechen bzw. nicht mehr zu einer wesentlichen Erhöhung des entsprechenden Widerstands führen kann. Auch eine etwa dadurch beeinträchtigte Lötfähigkeit ist ohne Belang.

In einer weiteren Ausgestaltung der Erfindung ist auf dem Grundkörpers eine Passivierung für die keramischen dielektrischen Schichten vorgesehen. Dafür sind z.B. Glasschichten gut geeignet, die sowohl eine gute Haftung, mechanische Stabilität als auch die nötige Dichtigkeit gegen Feuchte aufweist und somit auch einen ausreichenden Schutz der Keramik insbesondere gegen einen Angriff durch saure oder basische Metallabscheidebäder gewährleistet. Bei elektrisch leitfähigen Keramiken wie z.B. den Varistorkeramiken ist die Passivierung als elektrische Isolation erforderlich, wenn eine Galvanik zum Erzeugen der Lötkontakte eingesetzt wird. Für geringere Anforderungen an die Passivierung ist auch möglich, andere und zum Beispiel organische Schichten als Passivierung einzusetzen. Die Passivierung kann aufgedampft, aufgedruckt, aufgesputtert, aufgeschleudert, aufgetropft oder anderweitig aufgebracht werden.

Da der Lötkontakt frei von der Passivierung bleiben muss, wird er nach der Passivierung erzeugt. Um die auf der Passivierung zu erzeugenden Lötkontakte mit der jeweiligen Durchkontaktierung elektrisch zu kontaktieren, werden Öffnungen in der Passivierung freigelassen oder nachträglich erzeugt. Um eine ausreichende Toleranz bei Herstellung dieser Öffnungen zu schaffen, wird vor der Passivierung über den Durchkontaktierungen eine Kontaktfläche erzeugt, die eine ausreichende Fläche aufweist. Die Öffnungen in der Passivierung, über die der Lötkontakt dann Kontakt mit der Kontaktfläche und damit mit den Durchkontaktierungen hat, können dann über einem beliebigen Flächenbereich der Kontaktfläche angeordnet werden. Es ist daher erfindungsgemäß nicht erforderlich, die Öffnungen mit hoher Genauigkeit exakt über den Durchkontaktierungen anzuordnen, was die Prozesssicherheit erhöht.

In einem erfindungsgemäßen Mehrschichtbauelement können die Metallisierungen für die Durchkontaktierungen ausgewählt sein aus Silber (Ag), Palladium (Pd), Platin (Pt), Silberpalladium (AgPd), Silberplatin (AgPt), Silberpalladiumplatin (AgPdPt), Nickel (Ni), Kupfer (Cu) oder Gold (Au). Diese Materialien können in die entsprechenden Öffnungen/Bohrungen für die Durchkontaktierungen bereits auf der Stufe der Grünfolien eingebracht und zusammen mit diesen gesintert werden. Die Auswahl des entsprechenden Materials für die Durchkontaktierungen ist abhängig von dem Keramikmaterial und insbesondere von der für das Keramikmaterial erforderlichen Sintertemperatur. Bei niedrigsinternden Keramiken können die Durchkontaktierungen aus Silber hergestellt werden. Höhersinternde Keramiken wie beispielsweise HTCC-Keramiken erfordern temperaturbeständigere Materialien und insbesondere Platin.

Der auf der Unterseite des Grundkörpers aufsitzende Lötkontakt kann als direkt mit der keramischen Dielektrikumsschicht in Verbindung stehende unterste Schicht eine Haftvermittlerschicht aufweisen, die ausgewählt ist aus Nickel, Kupfer, Chrom oder Silber. Diese Materialien zeigen auf der Keramik eine besonders gute Haftung und erhöhen daher die Haftfähigkeit des gesamten Lötkontakts auch während des Betriebs des Bauelements.

Ein erfindungsgemäßes Bauelement kann für unterschiedliche Funktionen ausgelegt sein und wird durch Auswahl der Keramik und durch die Strukturierung der entsprechenden Metallisierungsebenen definiert. Das Bauelement kann als Mehrschichtvaristor, als keramischer Mehrschichtkondensator, als Mehrschichtthermistor oder als ein mehrschichtiges, eine Ferritkeramik umfassendes Bauelement ausgebildet sein.

Ein keramischer Mehrschichtkondensator zeichnet sich durch ein Dielektrikum mit hoher Dielektrizitätskonstante und durch eine in den Metallisierungsebenen realisiert Mehrschichtelektrodenstruktur aus, wobei zwei Typen von miteinander überlappenden Elektroden wechselseitig so übereinander angeordnet werden, dass eine gewünschte und insbesondere maximale Überlappungsfläche zwischen den unterschiedlichen Typen von Elektroden resultiert. Neben der Dielektrizitätskonstante ist für einen keramischen Mehrschichtkondensator noch das Temperaturverhalten maßgeblich, wobei ein erfindungsgemäßer als Mehrschichtkondensator ausgebildeter Grundkörper Dielektrikumsschichten umfasst, die aus den Temperaturklassen COG, X7R, Z5U und Y5V ausgewählt sein kann. Daneben oder alternativ kann das Bauelement auch Keramikschichten aus anderen Temperaturklassen enthalten.

Ein als keramischer Mehrschichtvaristor ausgebildetes erfindungsgemäßes Bauelement weist vorzugsweise im Grundkörper keramische Schichten aus Wismut dotiertem Zinkoxid (ZnO-Bi) oder Praseodym dotiertes Zinkoxid (ZnO-Pr) auf.

Der keramische Grundkörper kann auch eine LTCC- oder HTCC-Keramik umfassen. Werden Einzelschicht dieser Keramik aus den für Kondensatoren, Varistoren oder Thermistoren geeigneten Materialien ausgewählt, so können in der LTCC-Keramik auch Bauelementfunktionen als Zwei- oder Mehrschichtbauelement des Typs Kondensator, Thermistor, Varistor oder Ferritbauelement verwirklicht sein.

Der keramische. Grundkörper kann jedoch auch das Substrat eines Moduls sein, wobei mehrere aktive oder passive Komponenten auf der Oberseite des Grundkörpers angeordnet sind und mit im Innern des Grundkörpers angeordneten Bauelementstrukturen elektrisch verbunden sind, wobei die Bauelementstrukturen im Inneren als weitere passive Komponenten und/oder Verschaltungsstrukturen ausgebildet sind. Auch das Modul bzw. das Modulsubstrat kann mithilfe auf der Unterseite angeordneten Lötkontakte auf PCB-Leiterplatten aufgelötet werden, wobei sich die Vorteile der erfindungsgemäßen Lötkontakt- und Durchkontaktierungsausgestaltung auch hier bewähren und dem Modul zu einer verbesserten Haltbarkeit und damit höherer Lebensdauer verhelfen.

Im Folgenden wird die Erfindung anhand von Ausführungsbeispielen und der dazugehörigen Figuren näher erläutert. Die Figuren dienen allein dem besseren Verständnis der Erfindung und sind daher nur schematisch und nicht maßstabsgetreu ausgebildet. Auch Größenverhältnisse können verzerrt wiedergegeben sein und lassen keine Rückschlüsse auf tatsächliche relative Abmessungen zu.
- Figur 1: zeigt ausschnittsweise im schematischen Querschnitt ein erfindungsgemäßes Bauelement
- Figuren 2: bis 5 zeigen verschiedene Ausführungsformen erfindungsgemäßer Durchkontaktierungen anhand schematischer Querschnitte
- Figur 6: zeigt den Aufbau eines Lötkontakts im schematischen Querschnitt
- Figuren 7: bis 9 zeigen verschiedene Ausführungsbeispiele von elektrischen Bauelementen im schematischen Querschnitt
- Figur 10: zeigt ausschnittsweise ein mit einer Leiterplatte verlötetes Bauelement im schematischen Querschnitt
- Figur 11: zeigt ausschnittsweise ein Bauelement mit einer Passivierung
- Figur 12: zeigt ausschnittsweise ein Bauelement mit zusätzlicher Kontaktfläche unter der Passivierung und Lötkontakt
- Figur 13: zeigt ausschnittsweise ein Bauelement mit zusätzlicher Kontaktfläche unter der Passivierung und nicht zentriertem Lötkontakt
- Figur 14: zeigt ausschnittsweise ein Bauelement mit einer Passivierung und der Oberfläche der Durchkontaktierung als Lötkontakt.

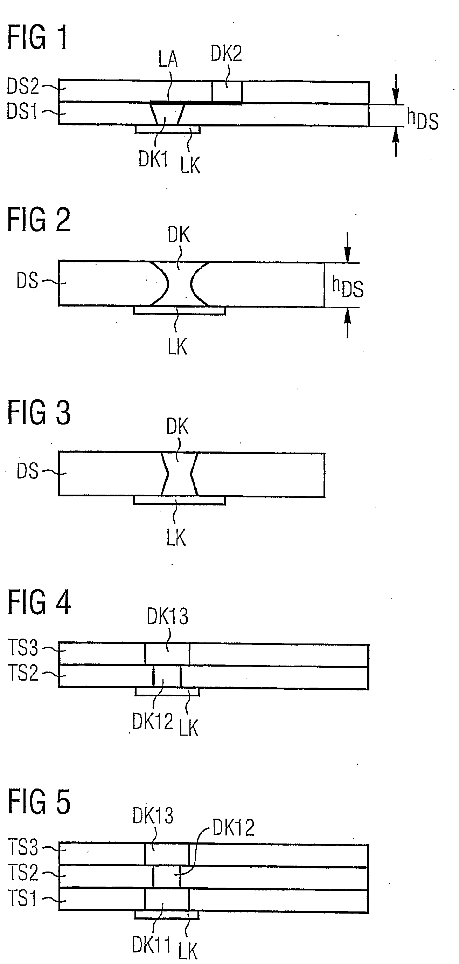

Figur 1 zeigt ausschnittsweise ein Mehrschichtbauelement im schematischen Querschnitt. Dargestellt sind zwei dielektrische Schichten DS1, DS2, zwischen denen eine Metallisierungsebene angeordnet ist, von der in der Figur nur ein Leiterabschnitt LA dargestellt ist. Nicht dargestellt sind weitere dielektrische Schichten und weitere zu Bauelementstrukturen strukturierte Metallisierungsebenen in gegebener beliebiger Anzahl, die den dargestellten Grundkörper "nach oben" fortsetzen. Auf der Unterseite US des Grundkörpers ist ein Lötkontakt LK angeordnet, der über eine Durchkontaktierung DK1 mit einer Metallisierungsebene, hier mit dem Leiterabschnitt LA verbunden ist. Die Durchkontaktierung DK1 weist zumindest abschnittsweise, hier über die gesamte Höhe h_{DS1} der untersten dielektrischen Schicht DS1, einen nach oben sich erweiternden Querschnitt auf. Von den weiteren vorhandenen Durchkontaktierungen, die weitere Metallisierungsebenen bzw. die darin angeordneten Bauelementstrukturen miteinander verbinden, ist hier nur eine weitere Durchkontaktierung DK2 eingezeichnet. Die weitere Durchkontaktierung kann wie dargestellt in bekannter Weise mit vertikalen Seitenwänden ausgebildet sein, kann aber ebenfalls wie die unterste zum Lötkontakt LK führende Durchkontaktierung DK1 mit sich nach oben erweiterndem Querschnitt ausgeführt sein. Ansonsten gilt für die Durchkontaktierungen, die auch als Vias bezeichnet werden, die für herkömmliche Durchkontaktierungen bekannten Herstellverfahren und Materialauswahlen. Auf die Herstellung der Durchkontaktierung wird später eingegangen.

Figur 2 zeigt eine weitere Ausgestaltung einer Durchkontaktierung DK1 in einer dielektrischen Schicht DS im schematischen Querschnitt. Diese Durchkontaktierung weist in einem mittleren Abschnitt ihren geringsten Querschnitt auf und besitzt konkave Außenkanten. Mit anderen Worten ausgedrückt besitzt die dielektrische Schicht DS zur Durchkontaktierung hin im Querschnitt abgerundete Kanten.

Figur 3 zeigt eine weitere mögliche Formgebung von Durchkontaktierungen DK1 durch eine dielektrische Schicht DS. Auch hier weist ein bezüglich der Höhe der dielektrischen Schicht h_{DS} gesehen mittlerer Abschnitt den geringsten Querschnitt auf. Von diesem mittleren Abschnitt an nimmt der Querschnitt linear ansteigend zu, und zwar in beide Richtungen - in Richtung Lötkontakt LK und in die entgegengesetzte Richtung. Dabei wird ein Querschnitt erhalten, der die Gestalt eines mit den Spitzen zusammenstoßenden Doppelkegels aufweist.

Erfindungsgemäß ausgebildete Durchkontaktierungen können mit entsprechend geformten z.B. rotierenden Werkzeugen in der vorgesehenen Form in einer keramischen Grünfolie als Bohrungen erzeugt und anschließend in an sich bekannter Weise metallisiert bzw. mit einer metallischen Masse befüllt werden. Möglich ist es auch, die Durchkontaktierung mit einer nicht vertikal gegen die Grünfolie gerichteten, Material abtragenden Bearbeitung zu erzeugen.

Ein elegantes Verfahren zur Herstellung von Durchkontaktierungen, die z.B. gemäß Figur 2 ausgebildet sind, besteht in einer kontrolliert geführten Herstellung des mehrschichtigen Grundkörpers. Durch eine geeignete Temperaturführung bei einem geeigneten Druck und einer geeigneten Metallisierung innerhalb der Durchkontaktierung gelingt es, die Durchkontaktierung bei Verpressen und dem anschließenden Sintern in der Mitte zu verengen, wobei sich die gewünschte Querschnittsform ergibt.

Figur 4 zeigt in einer erfindungsgemäßen Ausführung eine Durchkontaktierung, die durch zwei direkt benachbarte dielektrische Teilschichten TS2, TS3 geführt ist. Dabei unterscheidet sich die Durchkontaktierung durch die einzelnen Teilschichten bezüglich der Querschnittsfläche bzw. des Durchmessers. Die untere Durchkontaktierung DK12 durch die dielektrische Teilschicht TS2 weist einen geringeren Durchmesser auf als die obere Durchkontaktierung DK13 durch die zweite dielektrische Teilschicht TS3.

In Abwandlung von der Ausführung nach Figur 4 kann eine erfindungsgemäße Durchkontaktierung auch durch drei (oder mehr) dielektrische Teilschichten TS1 bis TS3 geführt werden, wobei die Durchkontaktierung DK12 durch die mittlere dielektrische Teilschicht TS2 den geringsten Durchmesser aufweist. Die Durchkontaktierungen DK13 durch die dritte Teilschicht TS3 und die Durchkontaktierung DK11 durch die erste Teilschicht TS1 weisen größeren Durchmesser als Durchkontaktierung DK12 auf.

Die Ausführungen nach Figuren 4 und 5 haben den Vorteil, dass sie sich ohne größeren Aufwand mit herkömmlichen Vorrichtungen und Verfahren zur Herstellung von Mehrschichtbauelementen einfach herstellen lassen, da die Teil-Durchkontaktierungen DK 11, DK12 durch die Teilschichten TS jeweils in herkömmlicher Weise mit vertikalen Seitenwänden geführt werden können.

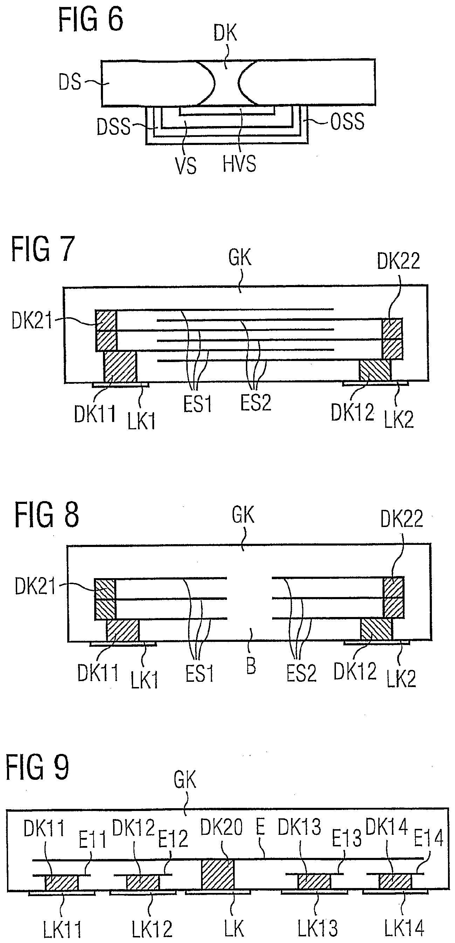

Figur 6 zeigt anhand eines schematischen Querschnitts den möglichen Aufbau eines erfindungsgemäßen Lötkontakts LK. Der Lötkontakt sitzt auf der Unterseite der untersten dielektrischen Schicht DS auf und ist vorzugsweise zentriert zur Durchkontaktierung DK1 angeordnet. Direkt über der Durchkontaktierung und darüber hinaus auf der Keramik aufsitzend ist eine haftvermittelnde Schicht HVS vorgesehen, die beispielsweise einen Glasanteil aufweist oder die zur Verbesserung der Haftung eines der Metalle Nickel, Kupfer, Chrom oder Silber umfasst. Diese haftvermittelnde Schicht HVS ist mit einer Verstärkungsschicht VS verstärkt, die die eigentliche metallische Basis des Lötkontakts zur Verfügung stellt. Eine weitere darüber angeordnete Schicht ist eine Diffusionssperrschicht DSS, die wiederum von einer Oxidationsschutzschicht OSS abgedeckt ist. Während die unterste haftvermittelnde Schicht HVS des Lötkontakts LK aufgedruckt oder aufgesputtert sein kann, können die darüber folgenden bzw. darüber aufgebrachten Schichten durch galvanische Verstärkung der haftvermittelnden Schicht oder ebenfalls durch Sputtern aufgebracht werden. Während die galvanische Verstärkung der haftvermittelnden Schicht HVS selbstjustierend ist, da eine Metallabscheidung nur an der bereits vorhandenen metallischen Schicht erfolgt, wird die Herstellung durch Sputtern z.B. mittels einer Maske definiert.

Figur 7 zeigt nähere Details einer möglichen Ausgestaltung der Bauelementstrukturen im Inneren des Grundkörpers GK. Dargestellt ist ein keramischer Mehrschichtkondensator, der einen ersten Stapel von Elektrodenschichten ES1 aufweist. Alternierend zu den Elektrodenschichten ES1 sind Elektrodenschichten ES2 eines zweiten Stapels so angeordnet, dass sich eine möglichst maximale Überlappungsfläche ergibt. Zumindest eine Elektrodenschicht ES eines jeden Elektrodenstapels ist über eine Durchkontaktierung DK11, DK12 mit einem eigenen Lötkontakt LK1, LK2 auf der Unterseite des Grundkörpers GK verbunden. Untereinander können die zu einem Elektrodenstapel gehörenden Elektrodenschichten ES ebenfalls durch Durchkontaktierungen DK21, DK22 verbunden sein, die in der Figur beispielsweise versetzt zu den Durchkontaktierungen DK1 angeordnet sind. Möglich ist es jedoch auch, die Durchkontaktierungen zum Verbinden der Elektrodenschichten ES eines Stapels und die Durchkontaktierung zur Verbindung des Stapels mit dem entsprechenden Lötkontakt LK übereinander zentriert bzw. konzentrisch anzuordnen. Die Durchkontaktierung DK12 ist in der Figur 7 beispielsweise durch zwei dielektrische Schichten geführt, wobei die Querschnittsform der Durchkontaktierungen durch die einzelnen Schichten für sich das erfindungsgemäße Design aufweisen kann, wie es beispielsweise für die Durchkontaktierung DK11 in Figur 7 dargestellt ist.

Figur 8 zeigt eine Ausgestaltung eines erfindungsgemäßen Bauelements als Varistor, bei der ebenfalls zwei Stapel von Elektrodenschichten ES1, ES2 im Grundkörper GK vorgesehen sind, wobei die Elektrodenschichten unterschiedlicher Stapel allerdings nicht überlappen. Ein Bereich B zwischen den Stapeln weist daher keine Elektroden auf. In Abhängigkeit von der Entfernung der Elektrodenschichten unterschiedlicher Stapel voneinander und der verwendeten Keramik bestimmt sich die Varistorspannung. Möglich ist es jedoch auch, ein Mehrschichtbauelement wie z.B. einen Kondensator oder einen Thermistor mit einer Elektrodenanordnung nach Figur 8 auszubilden. In diesem Fall bestimmt der Abstand zwischen den Elektrodenstapeln und das Keramikmaterial den Bauelementwiderstand bzw. die Kapazität.

Figur 9 zeigt im Querschnitt eine weitere Ausführungsform eines erfindungsgemäßen Mehrschichtbauelements, bei dem Elektroden E11 bis E14, die untereinander nicht überlappen, mit einer einzigen großflächigeren Elektrode E20 überlappen. Jede der Elektrodenschichten E11 bis E14 ist über eine eigene Durchkontaktierung DK11 bis DK14 mit einem eigenen Lötkontakt LK11 bis LK14 verbunden. Die Elektrodenschichten E20 ist über eine Durchkontaktierung DK20 mit einem Lötkontakt LK20 verbunden Die Durchkontaktierung kann dabei in Abhängigkeit von der Lage der zu kontaktierenden Elektrodenschicht über mehr als eine dielektrische Schicht geführt sein.

Der Einfachheit halber sind in den Figuren 7 bis 9 die erfindungsgemäßen Durchkontaktierungen zwar geradlinig dargestellt, können aber auch Querschnittsformen mit sich von Lotkontakt weg weisend verbreiternden Querschnitt aufweisen.

Während in den Figuren 7 bis 9 nur zwei Lötkontakte pro Bauelement dargestellt wurden, ist ein erfindungsgemäßes Bauelement jedoch nicht auf diese Anzahl beschränkt. Möglich ist es beispielsweise, Bauelementstrukturen bzw. Elektrodenschichten ES, Leiterbahnabschnitte LA oder andere Teile der Metallisierungsebenen parallel über mehrere Durchkontaktierungen DK mit gegebenenfalls mehreren Lötkontakten zu verbinden, um den entsprechenden Anschlusswiderstand zu reduzieren oder um den Flächenwiderstand von Elektrodenschichten, Leiterbahnabschnitten oder Bauelementstrukturen im Inneren des Grundkörpers GK zu überbrücken. Möglich ist es auch, mehr als zweipolare Bauelemente herzustellen, die mehrere Anschlüsse unterschiedlicher Polarität aufweisen, bzw. an die eine entsprechende Anzahl an Signale mit unterschiedlichem Potential angelegt werden kann. Dies ist insbesondere bei Bauelementen der Fall, die komplexe Verschaltungsstrukturen im Inneren aufweisen oder die mehrere Stapel von Elektrodenschichten besitzen, die einzeln über die entsprechenden Durchkontaktierungen und Lötkontakte ansprechbar sind oder über diese Elemente elektrisch miteinander verschaltbar sind.

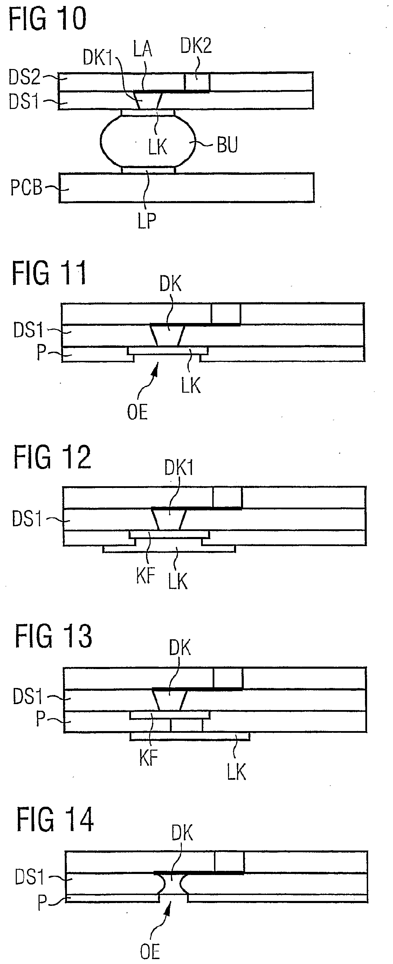

Figur 11 zeigt ausschnittsweise ein Bauelement mit einer Passivierung P, die hier über dem Lötkontakt LK aufgebracht ist. Eine Öffnung in der Passivierung lässt den Flächenbereich des Lötkontakts frei, auf den der Bump aufgebracht wird.

Figur 12 zeigt eine weitere Modifizierung des in Figur 11 beschriebenen Bauelements. Unter der Passivierung ist eine zusätzliche Kontaktfläche KF angeordnet. Der Lötkontakt LK über der Passivierung P steht in der Öffnung OE mit der Kontaktfläche und damit auch mit der Durchkontaktierung in Kontakt.

Figur 13 zeigt ausschnittsweise eine weitere Modifizierung des in Figur 12 beschriebenen Bauelements mit dem Unterschied, dass hier der Lötkontakt LK nicht zentriert über der Durchkontaktierung DK angeordnet ist. Die Passivierung ist z.B. eine Glasschicht.

Figur 14 zeigt ausschnittsweise ein Bauelement mit einer Passivierung P. Eine Öffnung OE in der Passivierung lässt den Flächenbereich des Durchkontaktierung frei, der dann direkt als Fläche für den Lötkontakt genutzt werden kann.

Figur 10 zeigt ausschnittsweise anhand einer einzigen Lötstelle die Verbindung eines erfindungsgemäßen Mehrschichtbauelements mittels einer Lotkugel bzw. eines Bumps BU mit einer Leiterplatte PCB. Über den Bump BU wird die Lötverbindung zwischen dem Lötkontakt LK auf der Unterseite des Grundkörpers GK und einem Lötpad LP auf der Oberseite der Leiterplatte PCB verbunden. Der Bump benetzt im verlöteten Zustand die gesamte Oberfläche der entsprechenden Lötkontakte LK bzw. Lötpads LP, so dass die Fläche dieser Kontakte bzw. Pads bei gegebenen Volumen des Bumps die Höhe des Bumps bestimmt und damit den Abstand, in dem der Grundkörper GK bzw. das Mehrschichtbauelement über der Leiterplatte PCB montiert ist.

Die in Figur 10 dargestellte Verlötung wird auch als Flip-Chip-Anordnung bezeichnet. In einem Schritt können dabei eine Vielzahl von Bumps BU die elektrische und mechanische Verbindung sämtlicher Lötkontakte LK auf der Unterseite des Bauelements mit den entsprechenden Pads auf der Oberfläche der Leiterplatte verbinden. Die Leiterplatte kann dabei als Ball Grid Array oder Land Grid Array ausgebildet sein.

Obwohl die Erfindung nur anhand weniger Ausführungsbeispiele beschrieben wurde, ist sie nicht auf diese beschränkt. Insbesondere umfasst die Erfindung beliebige Ausgestaltungen von Bauelementstrukturen, die in Metallisierungsebenen zwischen dielektrischen Schichten realisiert werden können. Solche Bauelementstrukturen können passive Bauelemente umfassen, die miteinander verschaltet sind, oder komplexe Verschaltungsstrukturen, die im Grundkörper realisierte passive Komponenten wie Widerstände, Kapazitäten, Induktivitäten umfassen. Für den Grundkörper bzw. die dielektrischen Schichten sind vorzugsweise die gleichen keramischen Materialien einsetzbar. Möglich ist es jedoch auch, innerhalb des Grundkörpers unterschiedliche dielektrische Schichten zu verwirklichen. Teile der dielektrischen Schichten können daher auch aus nichtkeramischen Materialien bestehen, beispielsweise aus Kunststoffen.

In vorteilhafter und ebenfalls nicht dargestellter Ausführung der Erfindung ist die Keramik bezüglich ihres thermischen Ausdehnungskoeffizienten an das Material der Leiterplatte PCB angepasst, was zusätzlich die thermischen Spannungen des gesamten Bauelements reduziert. Zwischen einer ZnO umfassenden dielektrischen Schicht und einer Leiterplatte aus FR4 Material besteht beispielsweise ein Unterschied im thermischen Ausdehnungskoeffizienten von nur 5,6 ppm. Eine derart gewählte Kombination von Materialien mit Unterschieden zwischen 5 und 7 ppm ist gegenüber bekannten Materialkombinationen, die Unterschiede im thermischen Ausdehnungskoeffizienten von 9 bis 11 aufweisen, wesentlich in der Haltbarkeit verbessert.

Ein erfindungsgemäßes Bauelement ist auch nicht auf die Anzahl der dielektrischen Schichten oder der dazwischen angeordneten Metallisierungsebenen mit Bauelementstrukturen beschränkt und ist beispielsweise ab zwei dielektrischen Schichten realisierbar. Nicht dargestellt ist auch die Ausführung, bei der der Grundkörper ausschließlich als Trägersubstrat für ein Modul dient, dessen Bauelemente auf und im Modulsubstrat angeordnet bzw. verwirklicht sind.

### Bezugszeichenliste

- GK: keramischer Grundkörper
- DS: dielektrische Schicht
- h_{DS}: Höhe der dielektrischen Schicht
- US: Unterseite der dielektrischen Schicht
- LA: Leiterbahnabschnitt in einer Metallisierungsebene
- LK: Lötkontakt
- DSS: Diffusionssperrschicht
- OSS: Oxidationsschutzschicht
- HVS: Haftvermittlerschicht
- TS: dielektrische Teilschicht
- ES: Elektrodenschicht
- LP: Lötpad
- PCB: Leiterplatte
- 10, 15, 20: Elektrodenschichten
- B: Bereich
- KF: Kontaktfläche
- P: Passivierung

## Patentansprüche

1. Elektrisches Mehrschichtbauelement
- ausgebildet als Mehrschichtvaristor, keramischer Mehrschichtkondensator, Thermistor oder als mehrschichtiges, eine Ferritkeramik umfassendes Bauelement
- mit einem keramischen Grundkörper (GK), der übereinandergestapelte keramische Dielektrikumsschichten (DS) umfasst,
- mit zwischen den Dielektrikumsschichten angeordneten Metallisierungsebenen, die zu Bauelementstrukturen (LA, ES) strukturiert sind
- mit Lötkontakten (LK) auf der Unterseite (US) des Grundkörpers, die zur Befestigung des Mehrschichtbauelements auf einer Leiterplatte mittels einer Lotverbindung ausgelegt sind**dadurch gekennzeichnet dass**
- eine Durchkontaktierung (DK) durch zwei direkt benachbarte Teilschichten (TS) einer Dielektrikumsschicht (DS) geführt und mit den Lötkontakten (LK) verbunden ist, wobei die Durchkontaktierung in jeder der beiden Teilschichten vertikale Seitenwände und unterschiedlichen Durchmesser aufweist, wobei der Durchmesser der Durchkontaktierung in der vom Lötkontakt weiter entfernten Teilschicht (TS3) größer ist als der einer näher am Lötkontakt liegenden Teilschicht (TS2).

2. Bauelement nach Anspruch 1,
bei dem die auf der Unterseite (US) des Grundkörpers (GK) aufgebrachten Lötkontakte (LK) die dort mündenden Durchkontaktierungen (DK) überlappen und an der Grenzfläche zum Grundkörper eine glashaltige Schicht (HVS) aufweisen.

3. Bauelement nach einem der Ansprüche 1 oder 2,
bei dem die Lötkontakte (LK) eine Schicht umfassen, die aus einem Material besteht, das ausgewählt ist aus Sn, SnPb, SnAgCu, SnAgCuBi, SnZn und SnAg.

4. Bauelement nach einem der Ansprüche 1 bis 3,
bei dem zwischen der Durchkontaktierung (DK) und dem Lötkontakt (LK) eine Diffusionssperrschicht (DSS) vorgesehen ist.

5. Bauelement nach Anspruch 4,
bei dem die Diffusionssperrschicht (DSS) ausgewählt ist aus Ni und Au.

6. Bauelement nach einem der Ansprüche 1 bis 5,
bei dem die Lötkontakte (LK) als äußerste Schicht eine Oxidationsschutzschicht (OSS) aufweisen.

7. Bauelement nach Anspruch 6,
bei dem die Oxidationsschutzschicht (OSS) ausgewählt ist aus Au, Sn und einer organischen Schicht.

8. Bauelement nach einem der Ansprüche 1 bis 7,
bei dem die Durchkontaktierungen (DK) zumindest ein Material umfassen, das ausgewählt ist aus Ag, Pd, Pt, AgPd, AgPt, AgPdPt, Ni, Cu und Au.

9. Bauelement nach einem der Ansprüche 1 bis 8,
bei dem die mit dem Grundkörper (GK) in Kontakt stehende unterste Schicht der Lötkontakte (LK) eine Haftvermittlerschicht (HVS) ist, die ausgewählt ist aus Ni, Cu, Cr und Ag.

10. Bauelement nach einem der Ansprüche 1 bis 9,
ausgebildet als keramischer Mehrschichtkondensator, wobei das Material für keramischen Grundkörper (GK) ausgewählt ist aus den Temperaturklassen COG, X7R, Z5U und Y5V.

11. Bauelement nach Anspruch 10,
ausgebildet als keramischer Mehrschichtvaristor, wobei das Material für keramischen Grundkörper (GK) ZnO-Bi oder ZnO-Pr umfasst.

12. Bauelement nach einem der Ansprüche 1 bis 11,
bei dem der keramische Grundkörper (GK) eine LTCC oder eine HTCC Keramik ist.

13. Bauelement nach einem der Ansprüche 1 bis 12,
bei dem der keramische Grundkörper (GK) als Substrat für ein Modul ausgebildet ist, wobei mehrere aktive oder passive Komponenten auf der Oberseite des Grundkörpers angeordnet und mit den Bauelementstrukturen im Innern des Grundkörpers elektrisch verbunden sind, wobei die genannten Bauelementstrukturen als weitere passive Komponenten und Verschaltungsstrukturen ausgebildet sind.

14. Bauelement nach einem der Ansprüche 1 bis 13,
bei dem auf dem Grundkörpers (GK) eine Passivierung (P) für die keramischen dielektrischen Schichten (DS) angeordnet ist.

15. Bauelement nach Anspruch 14,
bei dem direkt über den Durchkontaktierungen (DK) jeweils eine flächenmäßig größere Kontaktfläche (KF) vorgesehen ist, wobei die Passivierung (P) über der Kontaktfläche und der Lotkontakt (LK) auf der Passivierung angeordnet ist, wobei der Lotkontakt über Öffnungen (OE) in der Passivierung mit der Kontaktfläche elektrisch leitend verbunden ist.

## Claims

1. Electrical multi-layer component,
- embodied as a multi-layer varistor, a ceramic multi-layer capacitor, a thermistor or as a multi-layer component comprising a ferrite ceramic,
- having a ceramic main body (GK), which comprises ceramic dielectric layers (DS) stacked one on top of another,
- having metallization planes, which are arranged between the dielectric layers and are structured to form component structures (LA, ES),
- having solder contacts (LK) on the underside (US) of the main body, which are designed to fasten the multi-layer component on a printed circuit board by means of a soldered connection,
**characterized in that**
- a plated-through hole (DK) is passed through two directly adjacent sublayers (TS) of a dielectric layer (DS) and connected to the solder contacts (LK), wherein the plated-through hole has vertical side walls and different diameters in each of the two sublayers, wherein the diameter of the plated-through hole in the sublayer (TS3) further removed from the solder contact is greater than that of a sublayer (TS2) located closer to the solder contact.

2. Component according to Claim 1,
in which the solder contacts (LK) applied to the underside (US) of the main body (GK) overlap the plated-through holes (DK) opening out there, and have a glass-containing layer (HVS) at the interface with the main body.

3. Component according to either of Claims 1 and 2,
in which the solder contacts (LK) comprise a layer which consists of a material selected from Sn, SnPb, SnAgCu, SnAgCuBi, SnZn and SnAg.

4. Component according to one of Claims 1 to 3,
in which a diffusion barrier layer (DSS) is provided between the plated-through hole (DK) and the solder contact (LK).

5. Component according to Claim 4,
in which the diffusion barrier layer (DSS) is selected from Ni and Au.

6. Component according to one of Claims 1 to 5,
in which the solder contacts (LK) have an oxidation-resistant layer (OSS) as the outermost layer.

7. Component according to Claim 6,
in which the oxidation-resistant layer (OSS) is selected from Au, Sn and an organic layer.

8. Component according to one of Claims 1 to 7,
in which the plated-through holes (DK) comprise at least one material selected from Ag, Pd, Pt, AgPd, AgPt, AgPdPt, Ni, Cu and Au.

9. Component according to one of Claims 1 to 8,
in which the bottommost layer of the solder contacts (LK) which is in contact with the main body (GK) is an adhesion-promoter layer (HVS) selected from Ni, Cu, Cr and Ag.

10. Component according to one of Claims 1 to 9, embodied as a ceramic multi-layer capacitor, wherein the material for the ceramic main body (GK) is selected from the temperature classes COG, X7R, Z5U and Y5V.

11. Component according to Claim 10,
embodied as a ceramic multi-layer varistor, wherein the material for the ceramic main body (GK) comprises ZnO-Bi or ZnO-Pr.

12. Component according to one of Claims 1 to 11,
in which the ceramic main body (GK) is an LTCC or a HTCC ceramic.

13. Component according to one of Claims 1 to 12,
in which the ceramic main body (GK) is embodied as a substrate for a module, wherein a plurality of active or passive components are arranged on the top side of the main body and are electrically connected to the component structures in the interior of the main body, wherein said component structures are embodied as further passive components and interconnection structures.

14. Component according to one of Claims 1 to 13,
in which a passivation (P) for the ceramic dielectric layers (DS) is arranged on the main body (GK).

15. Component according to Claim 14,
in which a contact area (KF) of larger surface area is provided directly above each of the plated-through holes (DK), wherein the passivation (P) is arranged above the contact area and the solder contact (LK) is arranged on the passivation, wherein the solder contact is electrically conductively connected to the contact area via openings (OE) in the passivation.

## Revendications

1. Composant électrique multicouches,
- conçu sous la forme d'une varistance multicouches, d'un condensateur céramique multicouches, d'un thermistor ou d'un composant multicouches, comprenant une céramique-ferrite,
- avec un corps de base (GK) en céramique, qui comprend des couches diélectriques (DS) céramiques empilées les unes sur les autres,
- avec des niveaux de métallisation placés entre les couches diélectriques qui sont structurées en structures du composant (LA, ES),
- avec des contacts à braser (LK) sur la face inférieure (US) du corps de base, qui sont conçus pour fixer l'élément multicouches par brasure sur une carte de circuits imprimés **caractérisé en ce**
- **qu'**un contact de passage (DK) est tiré à travers deux couches partielles (TS) directement voisines d'une couche diélectrique (DS) et est assemblé avec les contacts à braser (LK), dans chacune des deux couches partielles, le contact de passage comportant des parois latérales verticales et différents diamètres, le diamètre du contact de passage dans la couche partielle (TS3) plus éloignée du contact à braser étant supérieur à celui d'une couche partielle (TS2) située plus près du contact à braser.

2. Composant selon la revendication 1,
sur lequel les contacts à braser (LK) appliqués sur la face inférieure (US) du corps de base (GK) chevauchent les contacts de passage (DK) qui y débouchent et comportent sur la surface de délimitation vers le corps de base une couche contenant du verre (HVS).

3. Composant selon l'une quelconque des revendications 1 ou 2,
sur lequel les contacts à braser (LK) comprennent une couche qui est composée d'une matière qui est choisie parmi le Sn, le SnPb, le SnAgCu, le SnAgCuBi, le SnZn et le SnAg.

4. Composant selon l'une quelconque des revendications 1 à 3,
sur lequel, entre le contact de passage (DK) et le contact à braser (LK) est prévue une couche formant barrière de diffusion (DSS).

5. Composant selon la revendication 4,
sur lequel la couche formant barrière de diffusion (DSS) est choisie parmi le Ni et l'Au.

6. Composant selon l'une quelconque des revendications 1 à 5,
sur lequel les contacts à braser (LK) comportent en tant que couche extérieure extrême une couche anti-oxydation (OSS).

7. Composant selon la revendication 6,
sur lequel la couche anti-oxydation (OSS) est choisie parmi l'Au, le Sn et une couche organique.

8. Composant selon l'une quelconque des revendications 1 à 7,
sur lequel les contacts de passage (DK) comprennent au moins une matière qui est choisie parmi l'Ag, le Pd, le Pt, l'AgPd, l'AgPt, l'AgPdPt, le Ni, le Cu et l'Au.

9. Composant selon l'une quelconque des revendications 1 à 8,
sur lequel la couche inférieure extrême des contacts à braser (LK) qui est en contact avec le corps de base (GK) est une couche d'agent adhésif (HVS) qui est choisie parmi le Ni, le Cu, le Cr et l'Ag.

10. Composant selon l'une quelconque des revendications 1 à 9,
conçu sous la forme d'un condensateur céramique multicouches, la matière pour le corps de base en céramique (GK) étant choisie parmi les classes de température COG, X7R, Z5U et Y5V.

11. Composant selon la revendication 10,
conçu en tant que varistance céramique multicouches, la matière pour le corps de base (GK) en céramique comprenant du ZnO-Bi ou du ZnO-Pr.

12. Composant selon l'une quelconque des revendications 1 à 11,
sur lequel le corps de base (GK) en céramique est une céramique LTCC ou HTCC.

13. Composant selon l'une quelconque des revendications 1 à 12,
sur lequel le corps de base (GK) en céramique est conçu sous la forme d'un substrat pour un module, plusieurs composants actifs ou passifs étant placés sur la face supérieure du corps de base et étant électriquement connectés avec les structures du composant à l'intérieur du corps de base, les structures du composant citées étant conçues sous la forme de composants passifs supplémentaires et de structures de câblage.

14. Composant selon l'une quelconque des revendications 1 à 13,
sur lequel une passivation (P) pour les couches diélectriques (DS) en céramique est placée sur le corps de base (GK).

15. Composant selon la revendication 14,
sur lequel directement au-dessus du contact de passage (DK), il est prévu chaque fois une surface de contact (KF) plus grande en surface, la passivation (P) étant placée au-dessus de la surface de contact et le contact à braser (LK) étant placé sur la passivation, le contact à braser étant assemblé de manière à conduire l'électricité avec la surface de contact par l'intermédiaire d'orifices (OE) dans la passivation.
